# EUROPEAN PATENT SPECIFICATION

(11) **EP 4 505 528 B1**
(45) Date of publication and mention of the grant of the patent: **12.08.2026**
(21) Application number: 23716479.3
(22) Date of filing: 30.03.2023
(51) Int. Cl.: H10F 19/80, H10F 19/00

(54) **METHOD FOR FABRICATING A PHOTOVOLTAIC MODULE USING IN-MOULD LABELING WITH SPECIFIC TEMPERATURE MANAGEMENT**
VERFAHREN ZUR HERSTELLUNG EINES FOTOVOLTAISCHEN MODULS MIT IN-MOULD-LABELING MIT SPEZIFISCHER TEMPERATURVERWALTUNG
PROCÉDÉ DE FABRICATION D'UN MODULE PHOTOVOLTAÏQUE FAISANT APPEL À UN ÉTIQUETAGE EN MOULE À GESTION DE TEMPÉRATURE SPÉCIFIQUE

(30) Priority: 04.04.2022 DE 102022108014
(43) Date of publication of application: 12.02.2025
(73) Proprietor: Sono Motors GmbH, 80935 München (DE)
(72) Inventor: BAUDRIT, Mathieu, 80636 München (DE); RAMESHA, Harshan Kalenahalli, 80796 München (DE); STERN GONZALEZ, Omar Ivan, 80995 München (DE); RIBEIRO, Eduardo Pastor Torcato, 80939 München (DE)
(74) Representative: Qip Patent & Recht Dr. Kuehn & Partner mbB
(86) International application number: PCT/EP2023/058369
(87) International publication number: WO 2023/194210

(56) References cited:
- EP-A1- 3 712 964
- WO-A1-2019/037837
- GB-A- 2 596 319
- GB-A- 2 596 522
- US-A1- 2010 319 754
- US-A1- 2019 181 283

## Description

### FIELD OF THE INVENTION

The present invention relates to a method for fabricating a photovoltaic module.

### BACKGROUND OF THE INVENTION

Photovoltaic modules comprise photovoltaic cells which may convert light energy into electric energy based on photovoltaic effects. Today, most commercial photovoltaic modules include photovoltaic cells which are manufactured based on semiconductor wafers such as silicon wafers. Wafer-based photovoltaic cells may be made with high conversion efficiencies at low costs. Furthermore, wafer-based photovoltaic cells may be manufactured using reliable industrial manufacturing processes.

In the following, the term "photovoltaic" may be abbreviated by "PV". PV cells are also referred to as solar cells.

Conventionally, a PV module comprises a stack of several sheets and layers as well as a carrier structure. Typically, a solar cell arrangement includes a plurality of PV cells and electrical connections interconnecting the PV cells. The PV cells and electrical connections are generally embedded in an encapsulation. The encapsulation encloses the PV cells in a tight manner and protects the PV cells against contact with gases such as air and liquids such as water. The encapsulation is typically formed by interposing the PV cells between a front side polymeric encapsulation foil and a rear side polymeric encapsulation foil. Such encapsulation foils are typically made with a thermoplastic polymer such as EVA (ethylene vinyl acetate). The encapsulation foils and the solar cells may then be heated and pressed such as to generate the solar cell arrangement in a form of a PV laminate. As the encapsulation foils are generally thin and therefore highly bendable, the encapsulation foils alone may not provide for a sufficiently stable and rigid bases for the PV module. Therefore, additionally to the PV laminate, the PV module further comprises a carrier structure. Conventionally, such carrier structure is provided by one or more rigid sheets. For example, a front side sheet, i.e. a sheet at a front side of the PV module to be directed towards incident light, may be made with a transparent glass plate. Such front side sheet may cover, protect and stabilise the PV cells. Additionally or alternatively, the carrier structure may comprise a rear side sheet formed for example by a glass plate or a metal sheet.

In fabricating a conventional PV module, the stack comprising the one or more rigid sheets and the solar cell arrangement is prepared. Therein, the solar cells are interposed between the front and rear side polymeric encapsulation foils, thereby forming the solar cell arrangement as a sub-stack. This sub-stack is placed on one rigid sheet or between two rigid sheets, thereby forming the entire stack. Subsequently, the entire stack is heated to an elevated temperature of e.g. more than 140°C. At such elevated temperature, the material of the polymeric encapsulation foils liquefies or at least comes to a viscous state such that the front side polymeric encapsulation foil and the rear side polymeric encapsulation foil are laminated to form a tight stack with the solar cells being comprised in between the two encapsulation foils and, furthermore, the polymeric encapsulation foils being joined with the one or more rigid sheets. Finally, a frame is typically arranged around the laminated entire stack. The frame provides additional mechanical stability and furthermore may serve for installing the PV module for example on top of a roof or on a pillar.

While such conventional fabricating of PV modules is well established, it may suffer from various deficiencies.

For example, laminating the solar cell arrangement to a carrier structure of one or more rigid sheets conventionally requires that the rigid sheets are planar. Accordingly, the entire PV module has a planar shape. However, there are various applications in which a PV module having a non-planar shape may be beneficial. For example, it has been proposed e.g. in an earlier patent application WO 2019/020718 A1 of the present applicant to integrate solar cells into a body part of a vehicle. Therein, the body part may have a non-planar, i.e. curved, shape and the PV module shall be placed on top of such body part or, preferably, the PV module shall be integrated into the body part or integrally forms the body part.

Furthermore, providing the PV module with a carrier structure formed for example by a glass sheet and/or a metal sheet may add substantial weight to the PV module and/or may add substantial costs for providing the glass sheet and/or metal sheet.

In order to overcome at least some of the above mentioned deficiencies, a new approach for manufacturing PV modules has been proposed by the present applicant in an earlier patent application WO 2020/187792 A1 (corresponding to EP 3712964 A1). Therein, a solar cell arrangement joined with a polymeric foil is integrated with a moulded layer formed by injection moulding. The moulded layer together with the integrated solar cell arrangement may form a PV module having a non-planar shape and may be manufactured at low costs. A process applied for fabricating such PV modules is similar to a technique known as in-mould labelling (IML). Possible features and characteristics of such approach for fabricating a photovoltaic module have been described by the applicant in prior patent applications such as two patent application filed in the United Kingdom with the application numbers GB 2596522 A (title: "Method for fabricating a photovoltaic module including laser cutting of a photovoltaic label") and GB2596319 A (title: "Method for fabricating a curved photovoltaic module including adapted positioning of photovoltaic cells"). Features and characteristics of such approach may also apply to the method described herein and the content of the earlier patent applications shall be incorporated in its entirety herein by reference.

However, it has been observed that, upon fabricating PV modules using injection moulding, care has to be taken in order to avoid deficiencies resulting for example in a non-optimum conversion efficiency of the PV module and/or a decreased longevity of the PV module. Particularly, it has been observed that degradations of the encapsulation encapsulating the PV cells in the solar cell arrangement may deteriorate the conversion efficiency and/or longevity of the PV module. Such degradations may result for example from delaminations of front and rear side polymeric encapsulation foils forming the encapsulation.

Accordingly, it may be an object to enable fabricating a PV module and overcome at least some of the above mentioned deficiencies. Particularly, it may be an object to enable fabricating a PV module, in particular a PV module with a non-planar shape, with high module efficiency, high reliability, high throughput, low costs and/or a high quality of the final PV module.

### SUMMARY OF THE INVENTION AND OF EMBODIMENTS

At least some of these objects may be achieved with a method as defined in the independent claim. Preferred embodiments are defined in the dependent claims as well as in the subsequent specification.

According to a first aspect of the invention, a method for fabricating a photovoltaic module comprising multiple photovoltaic cells is proposed. The method comprises at least the following steps, preferably, but not necessarily, in the indicated order:
- providing a photovoltaic label comprising a rear side polymeric stabilisation foil, a front side polymeric stabilisation foil and a solar cell arrangement interposed between the rear side polymeric stabilisation foil and the front side polymeric stabilisation foil, wherein the solar cell arrangement includes a plurality of solar cells electrically interconnected with each other and tightly embedded in an encapsulation;
- providing an in-mould labelling apparatus having a mould comprising a hollow space with a cavity portion and a core portion, the hollow space being enclosed by an inner surface of the mould and the inner surface including a cavity portion surface part defining the hollow space at the cavity portion and a core portion surface part defining the hollow space at the core portion;
- arranging the photovoltaic label in the cavity portion such that at least a major area of the front side polymeric stabilisation foil contacts the cavity portion surface part of the inner surface of the mould and such that at least a major portion of the rear side polymeric stabilisation foil is directed towards the core portion of the hollow space of the mould; and
- injecting a molten polymer into the core portion of the hollow space of the mould.

Therein, the encapsulation is configured such that its integrity deteriorates upon a temperature of the encapsulation exceeding a predefined deterioration temperature. The rear side polymeric stabilisation foil is made from a polymer material having a glass transition temperature higher than the deterioration temperature of the encapsulation. The mould is thermalized such that a first temperature at the cavity portion surface part of the mould is set lower than the deterioration temperature of the encapsulation. The molten polymer is injected with a second temperature being higher than the glass transition temperature of the polymer material of the rear side polymeric stabilisation foil.

Furthermore, a photovoltaic module is described. The PV module comprises:
- a photovoltaic label comprising a rear side polymeric stabilisation foil, a front side polymeric stabilisation foil and a solar cell arrangement interposed between the rear side polymeric stabilisation foil and the front side polymeric stabilisation foil, wherein the solar cell arrangement includes a plurality of solar cells electrically interconnected with each other and tightly embedded in an encapsulation; and
- a carrier structure of a mouldable polymer material, the carrier structure being connected to the photovoltaic label via a positive substance jointing of the mouldable polymer material with the rear side polymeric stabilisation foil of the photovoltaic label.

Therein, the rear side polymeric stabilisation foil is provided such as having a lower thermal conductance than the front side polymeric stabilisation foil.

Ideas underlying embodiments of the present invention may be interpreted as being based, inter alia and without restricting a scope of the invention, on the following observations and recognitions.

First, some basic ideas underlying embodiments of the present invention may be briefly summarised as follows:
A technique similar to in-mould labelling (IML) is assessed as a promising option for fabricating PV modules. Therein, a string of electrically interconnected solar cells is first encapsulated in an encapsulation and is then interposed between two polymeric stabilisation foils. Thereby, a so-called PV label is generated. Due to the stabilisation foils, such PV label is more stable than a conventional PV laminate in which the solar cells are only enclosed in very thin encapsulation foils. However, the PV label is nevertheless not sufficiently stable and self-supporting such as to generally form a PV module. Therefore, the PV label is reinforced with a carrier structure.

Such carrier structure is generated using injection moulding techniques. Therein, the PV label is temporarily arranged within a hollow space of a mould and a molten polymer is then injected into the hollow space. The injected polymer may attach to at least one of the stabilisation foils of the PV label. Preferably, the injected polymer establishes a positive substance jointing with the at least one of the stabilisation foils by temporarily glassifying the material of such foils. Upon cooling and solidifying, the injected polymer forms the carrier structure for the PV module.

However, it has been observed that processing parameters established during the IML-like injection moulding procedure may be critical and may substantially influence characteristics and a quality of the final PV module. Particularly, it has been observed that temperatures set in the mould as well as temperatures of the injected polymer may have to be managed very carefully in order to avoid substantial deteriorations in the final PV module. Specifically, it has been found that temperatures at portions of an inner surface of the mould enclosing the hollow space of the mould as well as temperatures of the molten polymer injected into the hollow space of the mould should be carefully selected and set with respect to each other.

Therein, the temperature management should be adapted such that, on the one hand, the molten polymer may establish the intended positive substance jointing with the PV label and, on the other hand, the encapsulation of the solar cell arrangement is not deteriorated during the injection moulding procedure. Particularly, it has been found that, during the injection moulding procedure, provisions should be taken and/or temperatures should be set such that, on the one hand, a surface of the rear side polymeric stabilisation foil is heated to beyond the glass transition temperature of the polymer material of this foil such that the injected molten polymer and the glassified polymer of the foil may combine for positive substance jointing. On the other hand, a temperature occurring at the encapsulation should remain sufficiently low such as to avoid deterioration, particularly such as to avoid delamination, at the encapsulation.

For such purpose, during the IML-like injection moulding procedure, the mould may be thermalised, i.e. set at temperatures, such that a cavity portion surface part of the mould adjoining the front side polymeric stabilisation foil of the PV label is lower than the deterioration temperature of the encapsulation. Accordingly, the PV label may be cooled at its front side due to the thermal contact of the front side polymeric stabilisation foil with the relatively cool cavity portion surface part of the mould. Preferably, such cooling action may prevent that a temperature of the encapsulation raises beyond the deterioration temperature during the injection moulding procedure, i.e. deteriorations due to excessive temperatures may be avoided in the encapsulation. Specifically, the deterioration temperature may be interpreted as a critical temperature beyond which the encapsulation is subjected to a deterioration which, under normal operation of the PV module, is irreversible. For example, the deterioration temperature may correspond to a glass transition temperature of a polymer forming the encapsulation or the deterioration temperature may be assumed to be within a temperature tolerance of e.g. ± 10°C or ± 20°C with regards to such glass transition temperature. Furthermore, during the IML-like injection moulding procedure, the temperature of the injected molten polymer should be sufficiently high such as to temporarily heat the rear side polymeric stabilisation foil beyond its glass transition temperature upon contact with the molten polymer.

In the proposed approach, a temperature distribution throughout the PV label during the IML-like injection moulding procedure may be influenced by carefully setting the temperatures of the inner surface of the mould, on the one hand, and the temperature of the injected molten polymer, on the other hand.

Additionally, physical characteristics of the front and rear side polymeric stabilisation foils of the PV label may be specifically configured such that a thermal conductance through the rear side polymeric stabilisation foil is lower than a thermal conductance through the front side polymeric stabilisation foil. Accordingly, the encapsulation of the solar cell arrangement being interposed between both stabilisation foils may be protected against excessive heating during the injection moulding procedure. Particularly, the encapsulation may be cooled due to the high thermal conductance through the front side polymeric stabilisation foil and due to the relatively low temperature of the cavity portion surface part of the mould contacting the front side polymeric stabilisation foil. On the other side, the encapsulation may be sufficiently thermally isolated with regard to the relatively hot injected molten polymer due to the low thermal conductance provided through the rear side polymeric stabilisation foil. In other words, with the highly thermally conductive front side polymeric stabilisation foil and the substantially lower thermal conductance of the rear side polymeric stabilisation foil, the encapsulation being interposed between both stabilisation foils may be thermally coupled to the relatively cool inner surface of the mould while being substantially thermally decoupled or isolated from the injected hot molten polymer. Accordingly, the temperature of the encapsulation may be held at a relatively low temperature during the injection moulding procedure, this temperature being closer to the temperature of the inner surface of the mould at the cavity portion surface part than to the temperature of the injected molten polymer. Therefore, the temperature of the encapsulation may be held below the deterioration temperature and deteriorations such as delaminations in the encapsulation may be avoided.

Next, possible details, features and advantages of embodiments of the proposed method for fabricating the PV module and of the PV module which may be fabricated by such method will be discussed:
The approach proposed herein is particularly suitable for fabricating PV modules comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 24%) and a high reliability. Furthermore, well established industrial processes exist for their fabrication. Such PV cells typically have lateral dimensions of between 50x50 mm² and 300x300 mm², mostly between 150x150 mm² and 200x200 mm², with a square shape, a rectangular shape, a round shape, a semi-round shape or any other shape. Furthermore, such PV cells generally have a thickness of more than 50 µm, typically between 100 µm and 300 µm. Having such thickness, the PV cells are relatively rigid, i.e. they may generally not be bent into small bending radii of e.g. less than their lateral dimensions. Each PV cell comprises electric contacts. The electric contacts of neighbouring PV cells may be interconnected via electrical connections such that these PV cells may be electrically connected in series, in parallel or any combination of series and parallel connections. The electrical connections may be provided by one or more electrically conducting ribbons and/or one or more copper solderings between two adjacent photovoltaic cells, preferably between each two adjacent photovoltaic cells of a respective string. A plurality of interconnected PV cells forms part of a solar cell arrangement, sometimes also referred to as solar cell string. The solar cell arrangement may further comprise additional components such as external contacts via which the solar cell arrangement may be connected to an external electric circuit, such external contacts sometimes being referred to as forming part of a junction box. Furthermore, the solar cell arrangement may comprise for example bypass diodes or other electric components. Additionally, one or more release loops for releasing mechanical tensions may be included in the solar cell arrangement.

Furthermore, the solar cell arrangement comprises the encapsulation into which the solar cells, the electrical interconnections and possibly other components are embedded. The encapsulation comprises or consists of a thermoplastic polymer such as EVA. Preferably, the polymer material forming the encapsulation has a relatively low melting temperature at which the material liquefies and/or an even lower glassifying temperature at which the material becomes partially viscous and sticky. Such melting temperature or glassifying temperature may be a temperature above which the polymer material may be processed for forming the encapsulation. For example, the encapsulation may be composed of a front side encapsulation foil and a rear side encapsulation foil enclosing the plurality of solar cells from opposite sides. In a lamination procedure, such front and rear side encapsulation foils may then be heated beyond the glassifying temperature of the polymeric material while being pressed against each other. Accordingly, the sticky visuous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material may form an encapsulation laminate. For such laminated encapsulation, the glassifying temperature or the melting temperature of the polymer may represent a deterioration temperature as, upon being heated beyond this deterioration temperature, the encapsulation may deteriorate with regard to its encapsulation characteristics, i.e. the previously laminated front and rear side encapsulation foils may for example delaminate from each other. For example, such deterioration temperature of the encapsulation may be lower than 150°C, alternatively lower than 130°C.

In the IML-like procedure used for fabricating the PV module, the solar cell arrangement including the solar cells, the electric connections and the encapsulation is reinforced by stabilisation foils for forming a PV label. Preferably, a front side polymeric stabilisation foil and a rear side polymeric stabilisation foil may enclose the interposed solar cell arrangement and may form a substrate and a superstrate, respectively, prior to performing e.g. the subsequent injection moulding step within the IML procedure. For example, the polymeric stabilisation foils may have a thickness of between 500µm and 2500µm. Each of the foils may adjoin and/or cover a part or an entirety of one of opposing surfaces of all of the PV cells. The polymeric stabilisation foils may be made with various polymeric materials such as ethylene vinyl acetate (EVA), polycarbonate (PC), polyethylenterephthalat (PET), polyamide (PA), polyetheretherketone (PEEK) or a mix of them. Particularly, a material forming the polymeric foil may be a thermoplastic material, i.e. a material which becomes plastic or viscous upon being heated to elevated temperatures. The front and rear side polymeric stabilisation foils may enclose the interposed solar cell arrangement and, upon being joined with each other, encapsulate the solar cell arrangement. Optionally, glass fiber reinforced or carbon fiber reinforced plastics may be included between the polymeric foils.

Particularly, the front side stabilisation polymeric foil, the rear side stabilisation polymeric foil and the PV cells may be joined together by an application of heat and/or a lamination process. In other words, after having arranged e.g. the rear side polymeric stabilisation foil, the solar cell arrangement and finally the front side polymeric stabilisation foil on top of each other in a lose manner, these stacked layers may be interconnected by mechanically joining with each other. Such joining may be induced for example by applying sufficient heat to the stack such that the polymeric material of the polymeric foils becomes viscous and/or sticky. Accordingly, upon such temporary application of heat, the polymeric stabilisation foils may mechanically interconnect with each other and/or with the interposed solar cell arrangement. Thus, the front and rear side polymeric stabilisation foils and the solar cell arrangement are joined in a lamination procedure. The lamination procedure may be integral with the lamination procedure used for forming the encapsulation embedding the PV cells, i.e. both the front and rear side polymeric stabilisation foils as well as the front and rear side polymeric encapsulation foils may be glassified or partially molten within a single lamination step. Alternatively, two separate lamination steps may be performed, i.e., first, the solar cell arrangement is laminated with the encapsulation foils enclosing the PV cells and, then, the PV label is laminated with the stabilisation foils enclosing the solar cell arrangement in between. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

The resulting PV label typically comprises various characteristics. For example, the PV cells included therein are protected at least to a certain degree against mechanical, electrical and/or chemical influences potentially damaging the solar cells. Furthermore, in the laminate forming the photovoltaic label, the PV cells are stabilized and mechanically interconnected with each other via the polymeric stabilisation foils enclosing the entire solar cell arrangement. Accordingly, the entire photovoltaic label may be easily handled for example during a subsequent PV module fabrication procedure.

However, the PV label alone generally does not have sufficient mechanical stability and/or rigidity required by a final PV module. In other words, the photovoltaic label is generally highly bendable at least in areas laterally in between neighbouring solar cells. Particularly, the photovoltaic label alone is generally not self-supporting. Accordingly, the PV label generally has to be provided with a carrier structure for forming a final product forming the PV module.

In order to prepare such carrier structure, an in-mould labelling apparatus may be used for injection moulding a polymer which forms the carrier structure and which adheres to the prefabricated PV label. Such in-mould labelling apparatus typically comprises a mould enclosing a hollow space. The mould may be made with a temperature resistant material such as a metal. The mould may be composed of several portions such that it may be opened to provide access to the hollow space in order to for example remove a moulded product. The hollow space generally has the form and contour of the product to be moulded.

Particularly and in contrast to a conventional injection moulding apparatus, an in-mould labelling apparatus is designed such that the hollow space enclosed by the mould comprises at least two different portions, namely a cavity portion and core portion. The two portions may be integral with each other, i.e. a fluid may flow from one portion into the other and vice versa. Particularly, the cavity portion may be adapted such as to accommodate the PV label. I.e., lateral dimensions of the cavity portion may correspond to lateral dimensions of the PV label. Furthermore, a thickness of the cavity portion may be adapted such as to enable accommodating at least a part of a thickness of the PV label. The core portion generally has dimensions corresponding to intended outer dimensions of the carrier structure. Accordingly, the entire inner surface enclosing the hollow space may be interpreted as being subdivided into a cavity portion surface part defining the hollow space at the cavity portion and a core portion surface part defining the hollow space at the core portion.

Upon the preparing of the carrier structure, the PV label may be arranged within the cavity portion. Particularly, the front side polymeric stabilisation foil or at least a major area thereof shall contact the cavity portion surface part of the inner surface of the mould. Therein, a mechanical contact between the front side polymeric lamination foil and the cavity portion surface part shall establish a highly conductive thermal contact between both contact partners. Upon such arranging of the PV label within the cavity portion, the rear side polymeric lamination foil is generally directed towards the core portion of the hollow space of the mould.

In such configuration, a polymer material which has previously been heated to an elevated temperature is injected into the core portion of the hollow space of the mould. Accordingly, the polymer being in a mouldable condition may distribute throughout the hollow space and, in filling the hollow space, may contact the PV label at its rear side polymeric stabilisation foil. Polymers which are suitable for such injection moulding may include thermoplastics, thermosets and elastomers. Materials such as polypropylene (PP), polycarbonate (PC), polyethylene (PE), polytetrafluoroethylene (PTFE), polyoxymethylene (POM), acrylonitrile butadiene styrene (ABS), a polyaryletherketone (PAEK), polyether ether ketone (PEEK), copolymers of polypropylene and ethylene, epoxy, phenolic, nylon, polystyrene (PS) and/or silicone (or any combination thereof) may be used for the injection moulded carrier structure. The hollow space of the mould defining the final shape of the moulded carrier structure may have any arbitrary shape. Particularly, such hollow space may have surfaces being curved in a convex and/or concave manner. Accordingly, the final PV module including the carrier structure and the PV label may have a complex shape and, particularly, may have a shape with non-uniformly curved surfaces corresponding for example to a functional component such as an outer body part of a vehicle.

During the in-mould labelling procedure, a specific temperature management should be established. This means that temperatures at the cavity portion surface part and the core portion surface part of the inner surface of the mould, on the one hand, and a temperature of the injected molten polymer, on the other hand, shall be set carefully within predefined temperature ranges.

Particularly, the mould may be thermalised such that temperatures at its inner surface may be set to predefined values. For example, the mould may comprise a fluid coolant system through which a fluid may be circulated and the fluid may be cooled. The mould may comprise a single coolant system for thermalizing its entire inner surface or portions thereof. Alternatively, the mould may have two or more coolant systems with which different areas of the inner surface may be thermalised to different temperatures, i.e. for example the cavity portion surface part may be thermalised to a first temperature whereas the core portion surface part may be thermalised to a different third temperature.

On the one side, the mould shall be thermalised such that the first temperature at the cavity portion surface part remains at a substantially lower temperature than the deterioration temperature of the encapsulation. For example, such first temperature may be more than 10°C, preferably more than 20°C, more than 40°C or even more than 60°C lower than the deterioration temperature of the encapsulation. As an example, when the encapsulation is made of EVA, the deterioration temperature may be assumed to be about 120°C and the first temperature at the cavity portion surface part may preferably be set to 60°C or even less. Accordingly, the PV label mechanically and thermally contacting such thermalised cavity portion surface part is effectively cooled by thermal conductance. In other words, thermal energy which may be absorbed in the PV label due to its contact to the hot molten polymer contacting the PV label at its rear side may be transferred to the thermalised cavity portion surface part at the front side of the PV label. Thus, the encapsulation being positioned between the front and the rear side stabilisation foils may be held at a sufficiently low temperature such as to avoid that its temperature raises beyond the deterioration temperature.

On the other side, the polymer to be injected into the core portion of the hollow space is heated to a second temperature which is higher than the glass transition temperature of the polymer material of the rear side polymeric stabilisation foil. Preferably, such second temperature is substantially higher than that mentioned glass transition temperature such that even when the molten polymer contacts the cooler rear side polymeric stabilisation foil, it still transfers sufficient thermal energy such as to heat the rear side polymeric stabilisation foil at least at its surface directly contacting the molten polymer to a temperature such that the polymer material of the stabilisation foil glassifies or even locally melts. Accordingly, a reliable and stable positive substance jointing may be established between the injected molten polymer and the rear side polymeric stabilisation foil upon subsequent cooling and solidifying. For example, the second temperature may be more than 10°, more than 20°, more than 40° or even more than 60° higher than the glass transition temperature of the polymeric material of the rear side polymeric stabilisation foil. For example, the second temperature may be higher than 200°C, preferably higher than 220°C or even higher than 240°C.

According to an embodiment, the mould may be thermalized such that a third temperature at the core portion surface part of the mould is set lower than the glass transition temperature of the polymer material of the rear side polymeric stabilisation foil.

In other words, while the injected polymer shall be hotter than the glass transition temperature of the polymer material of the rear side polymeric stabilisation foil, the wall of the mould enclosing the hollow space at the core portion surface part is preferably set to a lower temperature than such glass transition temperature. This means that such wall is cooler than the injected polymer. For example, the third temperature may be more than 10°C, more than 20°C, more than 40°C or more than 60°C cooler than the second temperature. Accordingly, upon contacting the inner surface of the mould, the molten injected polymer is substantially cooled. This may accelerate a solidification process. For example, the liquid molten polymer may first be injected into the core portion of the hollow space and may distribute throughout this core portion in order to fill the entire core portion. However, upon contacting the wall of the mould enclosing the core portion, the molten polymer quickly cools down. Accordingly, after a short solidification process of for example less then 60s or even less than 30s, the final product in the form of the PV module may be removed from the hollow space of the mould.

According to a further embodiment, the mould may be thermalized such that the first temperature at the cavity portion surface part of the mould is set lower than a third temperature at the core portion surface of the mould.

Expressed differently, the inner surface of the mould may be cooled to different temperatures in different areas thereof. Particularly, the cavity portion surface part may be cooled to a lower first temperature as compared to the third temperature established at the core portion surface part.

It has been found that, while the cavity portion surface part contacting and cooling the PV label should preferably be set to a very low first temperature of for example between 20°C and 80°C, preferably below 40°C or e.g. at room temperature, in order to effectively cool the PV label during the injection moulding procedure, the core portion surface part may preferably not be cooled to such low temperatures. Instead, it has been found that setting the third temperature at the core portion surface part to a higher temperature of for example between 50°C and 150°C, preferably between 80°C and 120°C or more preferably at 90°C±5°C, may enhance an overall quality of the resulting PV module. Particularly, it has been observed that upon setting the third temperature to an excessively low temperature, the carrier structure of the PV module generated by the injection moulding procedure may show deteriorations such as colourings at its surface.

Additionally to the described temperature management, characteristics of the PV label and particularly of the stabilisation foils comprised therein may be specifically adapted such as to support avoiding that the temperature of the encapsulation raises beyond the critical deterioration temperature during the IML injection moulding procedure.

Specifically, according to an embodiment, the rear side polymeric stabilisation foil may be provided such as having a lower thermal conductance than the front side polymeric stabilisation foil.

The thermal conductance is a measure of an ability of an object to allow the flow of heat from its warmer surface through the object to its colder surface, determined as the heat energy transferred per unit of time divided by the temperature difference between the two surfaces, expressed in watts per kelvin. The conductance of an object equals the thermal conductivity of its material times its surface area (cross-section) divided by the distance between the two surfaces (thickness). In other words, the thermal conductance is the reciprocal of thermal resistance.

By establishing the rear side polymeric stabilisation foil with a lower thermal conductance than the front side polymeric stabilisation foil, a beneficial temperature distribution may be achieved within the PV label during the injection moulding procedure. Specifically, a heating thermal flow from the hot injected molten polymer through the rear side polymeric stabilisation foil to the encapsulation may be kept small whereas a cooling thermal flow between the encapsulation and the cooled cavity portion surface part of the mould may be enhanced. As a result, a relatively low temperature within the encapsulation may be established, this temperature being closer to the first temperature of the cavity portion surface part then to the second temperature of the injected polymer.

The thermal conductance of the front and rear side polymeric stabilisation foils may be influenced in various manners.

For example, according to an embodiment, the rear side polymeric stabilisation foil may be thicker than the front side polymeric stabilisation foil.

Generally, the thermal conductance through a foil decreases with increasing thickness of the foil. Accordingly, in order to realise a high thermal conductance for the front side polymeric stabilisation foil, this stabilisation foil may be provided with a small thickness of for example between 200 µm and 1000µm, preferably between 400 µm and 800 µm. In contrast hereto, in order to realise a low thermal conductance, the rear side polymeric stabilisation foil may be provided with a large thickness of for example between 500 µm and 3000 µm, preferably between 750 µm and 2000 µm. For example, the thicknesses of the front and rear side polymeric stabilisation foils may differ from each other by more than 20%, preferably more than 50% or even more than 100%.

Additionally or alternatively, according to an embodiment, the rear side polymeric stabilisation foil may comprise a material having a lower thermal conductivity than a material of the front side polymeric stabilisation foil.

In other words, the front and rear side polymeric stabilisation foils may be provided with different materials having different thermal conductivities. Therein, the thermal conductivity of the material of the front side polymeric stabilisation foil may for example be more than 10%, preferably more than 20% or 50% or even 100% higher than the thermal conductivity of the material of the rear side polymeric stabilisation foil.

As a further alternative or additional measure, the rear side polymeric stabilisation foil may comprise a material which is configured to absorb heat due to a phase change upon heating from a temperature equal or higher than the first temperature to a temperature equal or lower than the second temperature.

There are various materials which, upon being heated or cooled, change their phase in a phase transition. Due to such phase change, such materials may absorb or release heat energy.

It has been found that, in the PV label discussed herein, it may be advantageous to provide the rear side polymeric stabilisation foil with a material which may absorb heat energy due to a phase change when being heated. Particularly, such material should be selected such that the energy absorbing phase change occurs at a temperature or in a temperature range being in between the first temperature of the cavity portion surface part of the mould and the second temperature of the injected molten polymer. Accordingly, such energy absorbing phase change occurs upon the rear side polymeric stabilisation foil being heated due to being contacted by the hot injected polymer during the IML injection moulding procedure. In other words, the rear side polymeric stabilisation foil is initially at the first temperature as the entire PV label is thermalised to the first temperature due to its thermal contact to the cavity portion surface part of the mould. However, as soon as the hot molten polymer is injected into the core portion and contacts the rear side of the PV label, the rear side polymeric stabilisation foil is heated to a temperature lying between the first temperature and the second temperature. In case the material of the rear side polymeric stabilisation foil is subjected to a phase transition during such temperature increase, at least a portion of the thermal energy transferred from the injected molten polymer to the rear side polymeric stabilisation foil is absorbed due to the phase change and will therefore not result in a temperature increase for the rear side polymeric stabilisation foil. Accordingly, the adjacent encapsulation may be protected against an excessive temperature increase. For example, the polymeric stabilisation foil may comprise 40 - 47% of glass fibers reinforcing the foil. Therein, the resin or polymer of the foil may undergo phase changes and may fuse with injected molten material upon cooling, while the glass fibers are bad thermal conductors and may therefore protect the adjacent material of the encapsulation foil from excessive temperature increase. As exemplary materials, glass-fibre reinforced polycarbonate (Gf-PC), glass-fibre reinforced acrylonitrile butadiene styrene (Gf-ABS), glass-fibre reinforced acrylonitrile styrene acrylate (ASA), glass-fibre reinforced polybutylene terephthalate (PBT) and/or mixtures of such materials may be used.

It shall be noted that possible features and advantages of embodiments of the invention are described herein with respect to a method for fabricating a PV module and to a PV module which may be fabricated using such method. One skilled in the art will recognize that the features may be suitably transferred from one embodiment to another and features may be modified, adapted, combined and/or replaced, etc. in order to come to further embodiments of the invention as defined by the scope of the claims.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 visualises characteristics of a method for fabricating a photovoltaic module according to an embodiment of the present invention.
Figs. 2 shows a cross-section through a PV label of a photovoltaic module fabricated in accordance with an embodiment of the present invention in a partial area "A" as indicated in Fig. 1.

The figures are only schematic and not to scale. Same reference signs refer to same or similar features.

### DESCRIPTION OF ADVANTAGEOUS EMBODIMENTS

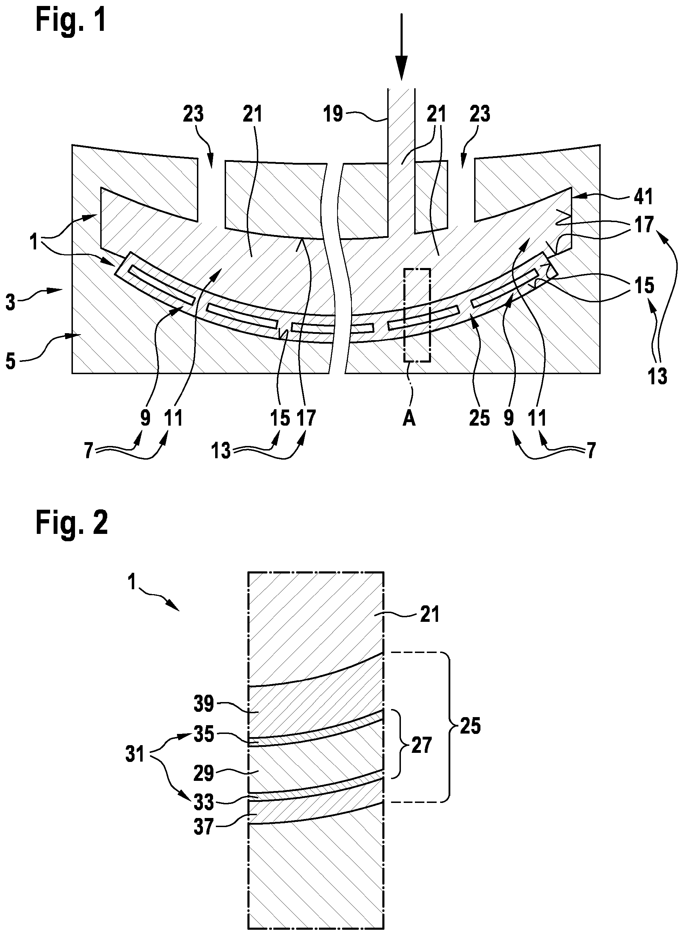

Fig. 1 visualises a photovoltaic module 1 upon being fabricated in an in-mould labelling apparatus 3. Fig. 2 shows an enlarged portion "A" as indicated in Fig. 1.

The in-mould labelling apparatus 3 comprises a mould 5. A hollow space 7 in the mould 5 comprises a cavity portion 9 and a core portion 11. The hollow space 7 is enclosed by an inner surface 13 of the mould 3. The inner surface 13 includes a cavity portion surface part 15 defining the hollow space 7 at the cavity portion 9. Furthermore, the inner surface 13 includes a core portion surface part 17 defining the hollow space 7 at the core portion 11. Furthermore, the in-mould labelling apparatus 3 comprises an inlet 19 through which a fluid material such as a molten polymer 21 may be injected into the hollow space 7. The inlet 19 is arranged such that the fluid material enters the hollow space 7 at the core portion 11. Optionally, more than one inlet 19 may be provided. Additionally, the in-mould labelling apparatus 3 comprises one or more outlets 23 through which air or excessive fluid material may exit the hollow space 7.

For fabricating the photovoltaic module 1, a PV label 25 is prepared. The PV label 25 comprises a stack of several layers and components. Specifically, the PV label 25 comprises a solar cell arrangement 27 including a plurality of solar cells 29 and an encapsulation 31. The solar cells 29 may be wafer-based silicon solar cells. Therein, the solar cells 29 are electrically connected with each other. Furthermore, the solar cells 29 are tightly embedded in the encapsulation 31. The encapsulation 31 comprises a front side encapsulation foil 33 and a rear side encapsulation foil 35. Both encapsulation foils 33, 35 consist of EVA material or a similar material and have a relatively small thickness of for example between 50 µm and 300 µm. The encapsulation foils 33, 35 and the interposed solar cells 29 form a PV laminate in which the encapsulation foils 33, 35 adhere to the solar cells 29 at both of their surfaces. In the PV label 25, the solar cell arrangement 27 is interposed between a front side polymeric stabilisation foil 37 and a rear side polymeric stabilisation foil 39. The front and rear side polymeric stabilisation foils 37, 39 may be made with a same or a different material as the encapsulation foils 33, 35. Generally, the front and rear side polymeric stabilisation foils 37, 39 have a substantially larger thickness and/or a higher mechanical stability than the encapsulation foils 33, 35. The entire stack comprising the solar cell arrangement 27 with the solar cells 29 and the encapsulation 31 together with the front and rear side polymeric stabilisation foils 37, 39 is then laminated to form the unitary PV label 25.

The PV label 25 is then introduced into the in-mould labelling apparatus 3. Specifically, the PV label 25 is arranged in the cavity portion 9 of the hollow space 7 such that at least a major area of the front side polymeric stabilisation foil 37 contacts the cavity portion surface part 15 of the inner surface 13 of the mould 5. Accordingly, at least a major portion of the rear side polymeric stabilisation foil 39 is directed towards the core portion 11 of the hollow space 7.

In such configuration, the mould 5 is thermalised such that the cavity portion surface part 15 is set to a first temperature which is lower than a deterioration temperature of the encapsulation 31. For example, the cavity portion surface part 15 is specifically thermalised, i.e. cooled, such that the first temperature is held at or below 100°C, preferably at or below 60°C. Accordingly, also the PV label 25 contacting this cavity portion surface part 15 is initially at such first temperature.

Then, the preheated molten polymer 21 is injected through the inlet 19 into the core portion 11 of the hollow space 7. The molten polymer 21 may be at a relatively high temperature above its melting temperature. For example, the molten polymer 21 may be at a second temperature of more than 200°C, preferably more than 260°C. Due to being liquid and highly viscous, the molten polymer 21 may spread throughout the core portion 11. Upon contacting the rear side polymeric stabilisation foil 39 of the PV label 25, heat will be transferred from the hot molten polymer 21 to the relatively cool PV label 25. Particularly, the hot molten polymer 21 may heat the surface of the rear side polymeric stabilisation foil 39 to a temperature above its glassifying temperature such that the injected molten polymer 21 and the glassified polymer of the rear side polymeric stabilisation foil 39 may form a positive substance jointing upon subsequent cooling and solidification.

However, due to the fact that the PV label 25 is in thermal contact with its front side polymeric stabilisation foil 37 mechanically contacting the cavity portion surface part 15 of the mould 5 and this cavity portion surface part 15 being thermalised to the relatively cool first temperature, the temperature of the encapsulation 31 may be prevented from raising beyond a critical limit. Particularly, the temperature of the encapsulation 31 may be prevented from raising beyond the deterioration temperature at which for example the front and rear side encapsulation foils 33, 35 become warmer than their glassifying temperature and may therefore delaminate from each other.

Furthermore, the stabilisation foils 37, 39 may be configured such that a thermal conductance through the rear side polymeric stabilisation foil 39 is lower than a thermal conductance through the front side polymeric stabilisation foil 37. For that purpose, the front side polymeric stabilisation foil 37 may have a smaller thickness and/or may be formed with a material having a higher thermal conductivity than the rear side polymeric stabilisation foil 39. Due to the thermal conductance being higher through the front side polymeric stabilisation foil 37 as compared to the rear side polymeric stabilisation foil 39, the intermediate encapsulation 31 remains at a relatively low temperature being closer to the first temperature then to the second temperature.

Furthermore, optionally, the rear side polymeric stabilisation foil 39 may comprise a material which is subjected to a phase change upon being heated from temperature being close to the first temperature to an elevated temperature being closer to the second temperature and wherein the material absorbs thermal energy due to the phase change. Due to such material characteristics, the rear side polymeric stabilisation foil 39 may additionally absorb thermal energy without excessively raising the temperature of the adjacent encapsulation 31.

With the proposed IML-like procedure, a photovoltaic module 1 may be fabricated in which the PV label 25 is integrally formed with a carrier structure 41. Therein, the carrier structure 41 is prepared by injection moulding the molten polymer 21 such that, on the one side, the polymer 21 of the carrier structure 41 is in a positive substance jointing with the polymer of the rear side polymeric stabilisation foil 39 of the PV label 25. On the other side, due to the specific temperature management established during the injection moulding procedure, deterioration of the encapsulation 31 of the PV label 25 is prevented.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### list of reference numerals:

- 1: PV module
- 3: in-mould labelling apparatus
- 5: mould
- 7: hollow space
- 9: cavity portion
- 11: core portion
- 13: inner surface
- 15: cavity portion surface part
- 17: core portion surface part
- 19: inlet
- 21: molten injected polymer
- 23: outlet
- 25: PV label
- 27: solar cell arrangement
- 29: solar cell
- 31: encapsulation
- 33: front side encapsulation foil
- 35: the rear side encapsulation foil
- 37: front side polymeric stabilisation foil
- 39: rear side polymeric stabilisation foil
- 41: carrier structure

## Claims

1. Method for fabricating a photovoltaic module (1) comprising multiple solar cells (29), the method at least comprising:
- providing a photovoltaic label (25) comprising a rear side polymeric stabilisation foil (39), a front side polymeric stabilisation foil (37) and a solar cell arrangement (27) interposed between the rear side polymeric stabilisation foil (39) and the front side polymeric stabilisation foil (37), wherein the solar cell arrangement (27) includes a plurality of solar cells (29) electrically interconnected with each other and tightly embedded in an encapsulation (31);
- providing an in-mould labelling apparatus (3) having a mould (5) comprising a hollow space (7) with a cavity portion (9) and a core portion (11), the hollow space (7) being enclosed by an inner surface (13) of the mould (5) and the inner surface (13) including a cavity portion surface part (15) defining the hollow space (7) at the cavity portion (9) and a core portion surface part (17) defining the hollow space (7) at the core portion (11);
- arranging the photovoltaic label (25) in the cavity portion (9) such that at least a major area of the front side polymeric stabilisation foil (37) contacts the cavity portion surface part (15) of the inner surface (13) of the mould (5) and such that at least a major portion of the rear side polymeric stabilisation foil (39) is directed towards the core portion (11) of the hollow space (7) of the mould (5);
- injecting a molten polymer (21) into the core portion (11) of the hollow space (7) of the mould (5);
wherein the encapsulation (31) is configured such that its integrity deteriorates upon a temperature of the encapsulation (31) exceeding a predefined deterioration temperature;
wherein the rear side polymeric stabilisation foil (39) is made from a polymer material having a glass transition temperature higher than the deterioration temperature of the encapsulation (31);
wherein the mould (5) is thermalized such that a first temperature at the cavity portion surface part (15) of the mould (5) is set lower than the deterioration temperature of the encapsulation (31); and
wherein the molten polymer (21) is injected with a second temperature being higher than the glass transition temperature of the polymer material of the rear side polymeric stabilisation foil (39).

2. Method according to claim 1,
wherein the mould (5) is thermalized such that a third temperature at the core portion surface part (17) of the mould (5) is set lower than the glass transition temperature of the polymer material of the rear side polymeric stabilisation foil (39).

3. Method according to one of the preceding claims,
wherein the mould (5) is thermalized such that the first temperature at the cavity portion surface part (15) of the mould (5) is set lower than a third temperature at the core portion surface part (17) of the mould (5).

4. Method according to one of the preceding claims,
wherein the deterioration temperature of the encapsulation (31) is lower than 150°C.

5. Method according to one of the preceding claims,
wherein the molten polymer (21) is injected with a second temperature being higher than 200°C, preferably higher than 260°C.

6. Method according to one of the preceding claims,
wherein the rear side polymeric stabilisation foil (39) is provided such as having a lower thermal conductance than the front side polymeric stabilisation foil (37).

7. Method according to one of the preceding claims,
wherein the rear side polymeric stabilisation foil (39) is thicker than the front side polymeric stabilisation foil (37).

8. Method according to one of the preceding claims,
wherein the rear side polymeric stabilisation foil (39) comprises a material having a lower thermal conductivity than a material of the front side polymeric stabilisation foil (37).

9. Method according to one of the preceding claims,
wherein the rear side polymeric stabilisation foil (39) comprises a material which is configured to absorb heat due to a phase change upon heating from a temperature equal or higher than the first temperature to a temperature equal or lower than the second temperature.

10. Method according to one of the preceding claims,
wherein the encapsulation (31) is composed of a front side encapsulation foil (33) and a rear side encapsulation foil (35) enclosing the plurality of solar cells (29) from opposite sides and being connected with each other to form a laminate.

11. Method according to one of the preceding claims,
wherein the encapsulation (31) consists of EVA material.

## Patentansprüche

1. Verfahren zur Herstellung eines Photovoltaik-Moduls (1) mit mehreren Solarzellen (29), wobei das Verfahren mindestens umfasst:
- Bereitstellen eines Photovoltaik-Labels (25), das eine rückseitige Polymer-Stabilisierungsfolie (39), eine vorderseitige Polymer-Stabilisierungsfolie (37) und eine Solarzellenanordnung (27) umfasst, die zwischen der rückseitigen Polymer-Stabilisierungsfolie (39) und der vorderseitigen Polymer-Stabilisierungsfolie (37) angeordnet ist, wobei die Solarzellenanordnung (27) eine Vielzahl von Solarzellen (29) umfasst, die elektrisch miteinander verbunden und dicht in einer Verkapselung (31) eingebettet sind;
- Bereitstellen einer In-Mould-Labelling-Vorrichtung (3) mit einer Form (5), die einen Hohlraum (7) mit einem Hohlraumabschnitt (9) und einem Kernabschnitt (11) umfasst, wobei der Hohlraum (7) von einer Innenfläche (13) der Form (5) umschlossen ist und die Innenfläche (13) einen Hohlraumabschnitt-Oberflächenteil (15), der den Hohlraum (7) am Hohlraumabschnitt (9) definiert, und einen Kemabschnitt-Oberflächenteil (17), der den Hohlraum (7) am Kernabschnitt (11) definiert, enthält;
- Anordnen des Photovoltaik-Labels (25) in dem Hohlraumabschnitt (9) derart, dass zumindest ein überwiegender Bereich der vorderseitigen Polymer-Stabilisierungsfolie (37) den Hohlraumabschnitt-Oberflächenteil (15) der Innenfläche (13) der Form (5) berührt und dass zumindest ein überwiegender Anteil der rückseitigen Polymer-Stabilisierungsfolie (39) hin zu dem Kernabschnitt (11) des Hohlraums (7) der Form (5) gerichtet ist;
- Einspritzen eines geschmolzenen Polymers (21) in den Kernbereich (11) des Hohlraums (7) der Form (5);
wobei die Verkapselung (31) so konfiguriert ist, dass sich ihre Intaktheit verschlechtert, wenn eine Temperatur der Verkapselung (31) eine vordefinierte Verschlechterungstemperatur überschreitet;
wobei die rückseitige Polymer-Stabilisierungsfolie (39) aus einem Polymermaterial hergestellt ist, das eine Glasübergangstemperatur aufweist, die höher ist als die Verschlechterungstemperatur der Verkapselung (31);
wobei die Form (5) so thermalisiert wird, dass eine erste Temperatur an dem Hohlraumabschnitt-Oberflächenteil (15) der Form (5) niedriger eingestellt ist als die Verschlechterungstemperatur der Verkapselung (31); und
wobei das geschmolzene Polymer (21) mit einer zweiten Temperatur eingespritzt wird, die höher ist als die Glasübergangstemperatur des Polymermaterials der rückseitigen Polymer-Stabilisierungsfolie (39).

2. Verfahren nach Anspruch 1,
wobei die Form (5) so thermalisiert wird, dass eine dritte Temperatur am Kernabschnitt-Oberflächenteil (17) der Form (5) niedriger als die Glasübergangstemperatur des Polymermaterials der rückseitigen Polymer-Stabilisierungsfolie (39) eingestellt wird.

3. Verfahren nach einem der vorhergehenden Ansprüche,
wobei die Form (5) so thermalisiert wird, dass die erste Temperatur an dem Hohlraumabschnitt-Oberflächenteil (15) der Form (5) niedriger eingestellt wird als eine dritte Temperatur an dem Kernabschnitt-Oberflächenteil (17) der Form (5).

4. Verfahren nach einem der vorhergehenden Ansprüche,
wobei die Verschlechterungstemperatur der Verkapselung (31) niedriger als 150°C ist.

5. Verfahren nach einem der vorhergehenden Ansprüche,
wobei das geschmolzene Polymer (21) mit einer zweiten Temperatur von mehr als 200°C, vorzugsweise mehr als 260°C, eingespritzt wird.

6. Verfahren nach einem der vorhergehenden Ansprüche,
wobei die rückseitige Polymer-Stabilisierungsfolie (39) so vorgesehen wird, dass sie eine geringere Wärmeleitfähigkeit aufweist als die vorderseitige Polymer-Stabilisierungsfolie (37).

7. Verfahren nach einem der vorhergehenden Ansprüche,
wobei die rückseitige Polymer-Stabilisierungsfolie (39) dicker ist als die vorderseitige Polymer-Stabilisierungsfolie (37).

8. Verfahren nach einem der vorhergehenden Ansprüche,
wobei die rückseitige Polymer-Stabilisierungsfolie (39) ein Material mit einer geringeren Wärmeleitfähigkeit als ein Material der vorderseitigen Polymer-Stabilisierungsfolie (37) aufweist.

9. Verfahren nach einem der vorhergehenden Ansprüche,
wobei die rückseitige Polymer-Stabilisierungsfolie (39) ein Material aufweist, das so konfiguriert ist, dass es aufgrund einer Phasenänderung beim Erhitzen von einer Temperatur gleich oder höher als die erste Temperatur auf eine Temperatur gleich oder niedriger als die zweite Temperatur Wärme absorbiert.

10. Verfahren nach einem der vorhergehenden Ansprüche,
wobei die Verkapselung (31) aus einer vorderseitigen Verkapselungsfolie (33) und einer rückseitigen Verkapselungsfolie (35) besteht, die die Mehrzahl der Solarzellen (29) von gegenüberliegenden Seiten umschließen und miteinander zum Bilden eines Laminats verbunden sind.

11. Verfahren nach einem der vorhergehenden Ansprüche,
wobei die Verkapselung (31) aus EVA-Material besteht.

## Revendications

1. Procédé de fabrication d'un module photovoltaïque (1) comprenant de multiples cellules solaires (29), le procédé comprenant au moins:
- la fourniture d'une étiquette photovoltaïque (25) comprenant une feuille de stabilisation polymère côté arrière (39), une feuille de stabilisation polymère côté avant (37) et un agencement de cellules solaires (27) interposé entre la feuille de stabilisation polymère côté arrière (39) et la feuille de stabilisation polymère côté avant (37), dans lequel l'agencement de cellules solaires (27) comprend une pluralité de cellules solaires (29) interconnectées électriquement les unes aux autres et étroitement intégrées dans une encapsulation (31) ;
- la fourniture d'un appareil d'étiquetage dans le moule (3) ayant un moule (5) comprenant un espace creux (7) avec une partie de cavité (9) et une partie de noyau (11), l'espace creux (7) étant enfermé par une surface interne (13) du moule (5) et la surface interne (13) comprenant une partie de surface de partie de cavité (15) définissant l'espace creux (7) au niveau de la partie de cavité (9) et une partie de surface de partie de noyau (17) définissant l'espace creux (7) au niveau de la partie de noyau (11) ;
- l'agencement de l'étiquette photovoltaïque (25) dans la partie de cavité (9) de sorte qu'au moins une zone majeure de la feuille de stabilisation polymère côté avant (37) est en contact avec la partie de surface de partie de cavité (15) de la surface interne (13) du moule (5) et de sorte qu'au moins une partie majeure de la feuille de stabilisation polymère côté arrière (39) est dirigée vers la partie de noyau (11) de l'espace creux (7) du moule (5) ;
- l'injection d'un polymère fondu (21) dans la partie de noyau (11) de l'espace creux (7) du moule (5) ;
dans lequel l'encapsulation (31) est configurée de sorte que son intégrité se détériore lorsqu'une température de l'encapsulation (31) dépasse une température de détérioration prédéfinie ;
dans lequel la feuille de stabilisation polymère côté arrière (39) est fabriquée à partir d'un matériau polymère ayant une température de transition vitreuse supérieure à la température de détérioration de l'encapsulation (31) ;
dans lequel le moule (5) est thermalisé de sorte qu'une première température au niveau de la partie de surface de partie de cavité (15) du moule (5) est mis inférieure à la température de détérioration de l'encapsulation (31) ; et
dans lequel le polymère fondu (21) est injecté avec une seconde température qui est supérieure à la température de transition vitreuse du matériau polymère de la feuille de stabilisation polymère côté arrière (39).

2. Procédé selon la revendication 1,
dans lequel le moule (5) est thermalisé de sorte qu'une troisième température au niveau de la partie de surface de partie de noyau (17) du moule (5) est mis inférieure à la température de transition vitreuse du matériau polymère de la feuille de stabilisation polymère côté arrière (39).

3. Procédé selon l'une des revendications précédentes,
dans lequel le moule (5) est thermalisé de sorte que la première température au niveau de la partie de surface de partie de cavité (15) du moule (5) est réglée inférieure à une troisième température au niveau de la partie de surface de partie de noyau (17) du moule (5).

4. Procédé selon l'une des revendications précédentes,
dans lequel la température de détérioration de l'encapsulation (31) est inférieure à 150 °C.

5. Procédé selon l'une des revendications précédentes,
dans lequel le polymère fondu (21) est injecté avec une seconde température qui est supérieure à 200 °C, de préférence supérieure à 260 °C.

6. Procédé selon l'une des revendications précédentes,
dans lequel la feuille de stabilisation polymère côté arrière (39) est prévue de manière à avoir une conductivité thermique inférieure à celle de la feuille de stabilisation polymère côté avant (37).

7. Procédé selon l'une des revendications précédentes,
dans lequel la feuille de stabilisation polymère côté arrière (39) est plus épaisse que la feuille de stabilisation polymère côté avant (37).

8. Procédé selon l'une des revendications précédentes,
dans lequel la feuille de stabilisation polymère côté arrière (39) comprend un matériau ayant une conductivité thermique inférieure à celle d'un matériau de la feuille de stabilisation polymère côté avant (37).

9. Procédé selon l'une des revendications précédentes,
dans lequel la feuille de stabilisation polymère côté arrière (39) comprend un matériau qui est configuré pour absorber la chaleur due à un changement de phase lors du chauffage d'une température égale ou supérieure à la première température à une température égale ou inférieure à la seconde température.

10. Procédé selon l'une des revendications précédentes,
dans lequel l'encapsulation (31) est composée d'une feuille d'encapsulation côté avant (33) et d'une feuille d'encapsulation côté arrière (35) enfermant la pluralité de cellules solaires (29) à partir de côtés opposés et étant connectées les unes aux autres pour former un stratifié.

11. Procédé selon l'une des revendications précédentes,
dans lequel l'encapsulation (31) est constituée d'un matériau EVA.
